# EUROPEAN PATENT SPECIFICATION

(11) **EP 1 308 962 B1**
(45) Date of publication and mention of the grant of the patent: **05.03.2008**
(21) Application number: 02024258.2
(22) Date of filing: 31.10.2002
(51) Int. Cl.: G11C 16/04

(54) **Single poly embedded EPROM**
Eingebetteter EPROM-Speicher mit einer einzigen Polysiliziumschicht
Mémoire EPROM encastrée à un seul niveau de polysilicium

(30) Priority: 02.11.2001 CN 01136877
(43) Date of publication of application: 07.05.2003
(73) Proprietor: eMemory Technology Inc., Hsinchu City (TW)
(72) Inventor: Yang, Ching-Sung, Hsi-Hu Town, Chang-Hua-Hsien (TW); Shen, Shih-Jye, Hsin-Chu Hsein (TW); Hsu, Ching-Hsiang, Hsin-Chu City (TW)
(74) Representative: Schaeberle, Steffen

(56) References cited:
- US-A- 3 843 954
- US-A- 4 733 375
- US-A- 6 118 691
- US-A- 6 166 954

## Description

The present invention relates to an erasable programmable read only memory according to the precharacterizing clause of claim 1.

The semiconductor industry has advanced to the field of ultra large scale integrated (ULSI) technologies. The fabrication of nonvolatile memories also follows this trend of size reduction. Thanks to their advantages, such as non-volatility, fast access time and low power dissipation, non-volatile memory can be applied as portable handheld equipment, solid-state cameras, and PC-cards. Nonvolatile memories include various types of devices, such as EAROM (electrically alterable read only memory), and EEPROM (electrically erasable programmable read only memory). Different types of devices have been developed for specific applications. These parts have been developed with a focus on the high endurance and high-speed requirements. EEPROM requires multiple layers of polysilicon and silicon oxide, and therefore, multi-masking is used during fabrication, thereby increasing the time for manufacturing devices. Of present industry interest is how to integrate the manufacturing processes to reduce costs. One of the approaches is to integrate the memory process with CMOS fabrication. Until now, many approaches have been towards the formation of the EPROM and EEPROM by using one single poly process. In this technique, a control gate is buried in silicon bulk by ion implantation. EPROM or OTP, which is compatible with the single poly process, plays a more important role in the semiconductor field.

US 3,843,954 shows a high-voltage integrated driver circuit for driving the word lines of a digital computer memory array of floating-gate avalanche-injection transistor memory cells. The described memory cell is called a "floating-gate avalanche-injection metal-oxide semiconductor", otherwise known as a "FAMOS" device as disclosed in a paper by D. Frohmann-Bentchkowsky, entitled "A fully-decoded 2048-bit electrically-programmable MOS ROM", 1971, IEEE, International Solid-State Circuits Conference, Feb. 18, 1971.

This in mind, the present invention aims at providing a further erasable programmable read only memory structure.

This is achieved by an erasable programmable read only memory structure according to claim 1. The dependent claims pertain to corresponding further developments and improvements.

As will be seen more clearly from the detailed description following below, the claimed erasable programmable read only memory includes two serially connected P-type metal-oxide semiconductor (PMOS) transistors. Wherein a first PMOS transistor acts as a select transistor, a second PMOS transistor, wherein a gate of the second PMOS transistor serves as a floating gate, biasing a drain of the second PMOS transistor to a first negative bias, thereby providing a second negative bias on the floating gate to perform programming mode without applying a certain bias on a control gate.

In the following, the invention is further illustrated by way of example, taking reference to the accompanying drawings. Thereof
Fig. 1 shows a layout according to the prior art,
Fig.2 shows another layout according to the prior art,
Fig.3 shows the circuit according to the present invention,
Fig.4 illustrates a layout according to the present invention,
Fig.5 is a cross sectional view of a substrate illustrating the programming mode of writing the status "1" according to the present invention,
Fig.6 is a cross sectional view of a substrate illustrating the programming mode of writing the status "0" according to the present invention,
Fig.7 and 8 are cross sectional views of a substrate illustrating the reading mode according to the present invention,
Fig.9 shows the drain current-voltage drawing according to the present invention,
Fig. 10 shows the gate current-voltage drawing according to the present invention, and
Fig.11 illustrates the memory cell array according to the present invention.

The prior art that relates to this field is disclosed in the US Patent No. 6,174,759 to Verhaar, entitled "Method of manufacturing a semiconductor device". The assignee is US Philips Corporation (New York, NY) and filed the prior art on May 3, 1999. The method disclosed a process that can integrate with the CMOS process. Lucent Technologies, Inc. disclosed a single poly EEPROM on 5, 31, 2000 in US Patent No. 6,191,980. The device includes control device, switch device and erase device, all of which share a common polysilicon floating gate which is designed to retain charge in the programmed memory cell. The memory cell can be safely erased without risking the junction breakdowns. Mosel Vitelic, Inc. (Hsinchu, Taiwan) disclosed a single poly memory and filed on 6, 17, 1998, entitled "Single-poly flash memory cell for embedded application and related methods". The prior art can be found in US Patent No. 6,044,018. The prior art includes a single-poly flash memory cell manufacturable by a standard CMOS fabrication process. A NMOS floating gate is electrically connected to a PMOS floating gate.

In the article IEEE transaction on electron device, Vol. 37, No. 3, March 1990 p. 675, in which disclosed single poly-Si EEPROM. The structure includes an embedded control gate that is formed by ion implantation. The cell includes separated transistor and coupled capacitor and can be manufactured by standard CMOS process. The further technique that can be compatible with the CMOS can be found in IEEE JOURNAL OF SOLID STATE CIRCUITS, Vol. 29, No. 3, 1994, p. 311. The structure includes NMOS and PMOS, the inversion layers under the PMOS gate and p+ doped region act as the control gate. When positive voltage applies to the p+ doped region, the voltage level of the floating gate determines the capacitance ratio of the NMOS and PMOS. The art may be formed by standard CMOS processes. The structure refers to SIPPOS (single poly pure CMOS).

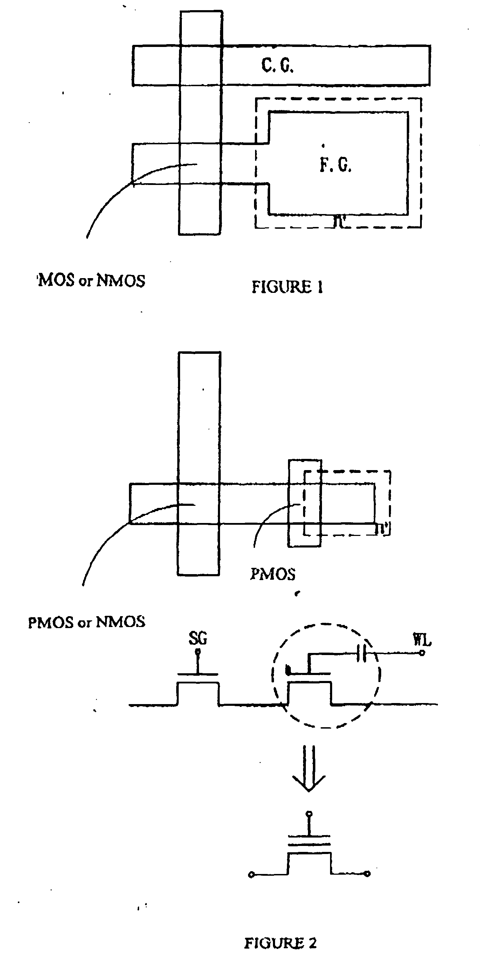

Fig.1 shows the layout of prior single poly non-volatile memory, the structure includes n+ doped region under the floating gate and buried in the substrate. The structure occupies too much area. Fig.2 shows another type of layer according to the prior art. The structure consists of a capacitor and a PMOS. The technique has to provide space for forming the capacitor. Consequently, there is a need to provide an erasable and programmable read only memory cell with a smaller space.

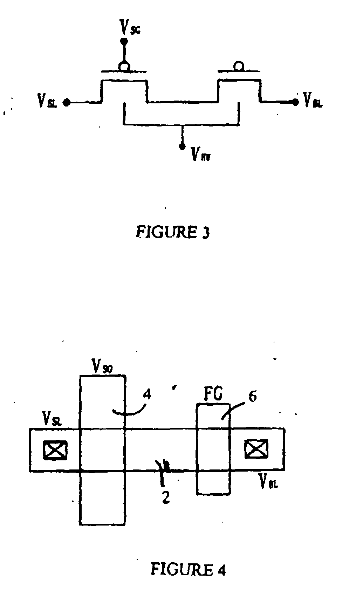

Fig.3 shows the circuit according to the present invention. The device includes two serially connected PMOS transistors, the first PMOS transistor is used as select transistors and the gate of the transistor is connected to the select gate voltage (V_{SG}). The first terminal (source) of the first PMOS transistor is biased to source line voltage, and the second terminal (drain) is connected to the first terminal of the second PMOS transistor and the second terminal of the second PMOS is connected to the bit line voltage (V_{BL}). The gate of the second PMOS transistor acts as the floating gate. It has to be noted that the cell according to the present invention omits the control gate compared to the prior art. The channel hot carrier will inject onto the floating gate by applying suitable bias.

Fig.4 shows the EPROM layout of the present invention, the device includes a doped region 2 (lateral configuration area in the drawing). Typically, the doped region can be formed by ion implantation, the doped region 2 can be shaped into a stripe structure. A first conductive area 4 and a second conductive area 6 are covered on the overlap area to act as selecting transistor gate and floating gate. The gate of the selecting transistor comprises a stripe structure and is connected to selecting gate voltage (V_{SG}). One of the aspects of the present invention is that the control gate is omitted, therefore, the present invention may reduce the device size, meet the requirement of the IC trend and integrate with CMOS process. The bit line and contact window of the selecting line can be formed and aligned to the doped region 2 by using lithography and etching process.

The second conductive area 6 is located at the side of the first conductive area 4 and on the substrate forms cross configuration structure with overlap area to act as floating gate. The programming operation is achieved by using channel hot electron injection (CHE) and the floating gate is charged by hot electrons in the programming gate, the voltage level of the floating gate is less than ground level. The device cell keeps "turned on". During the erase mode, the digital states may be altered by exposing using ultra violate (UV) ray to alter the state. In the erase state, there is no charge in the floating gate.

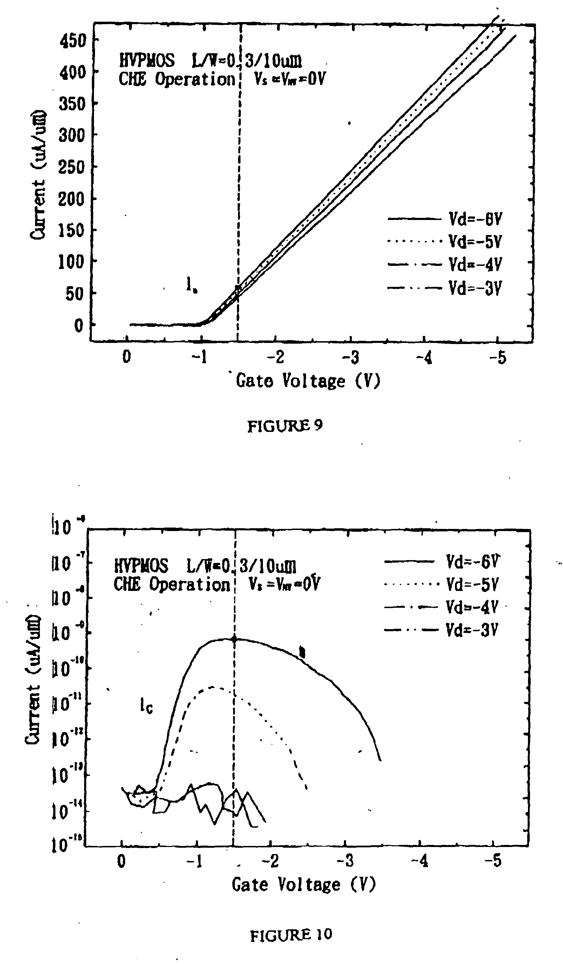

Fig.9 illustrates the drain current-voltage characteristic and Fig.10 shows the gate current-voltage characteristic. In Fig.10, the drain bias is negative five or six volts. At the current peek value of the gate current, the PMOS gate bias is about negative one volt. Under such a circumstance, the carrier will inject onto the floating gate. Thus, the control gate is omitted. The term "automatically inject" refers to that the device does not need to apply bias on the control gate for programming. With reduction of the floating gate bias, the programming mode is then "turned off". The higher I_{G}/I_{D} efficient can be obtained with lower power consumption.

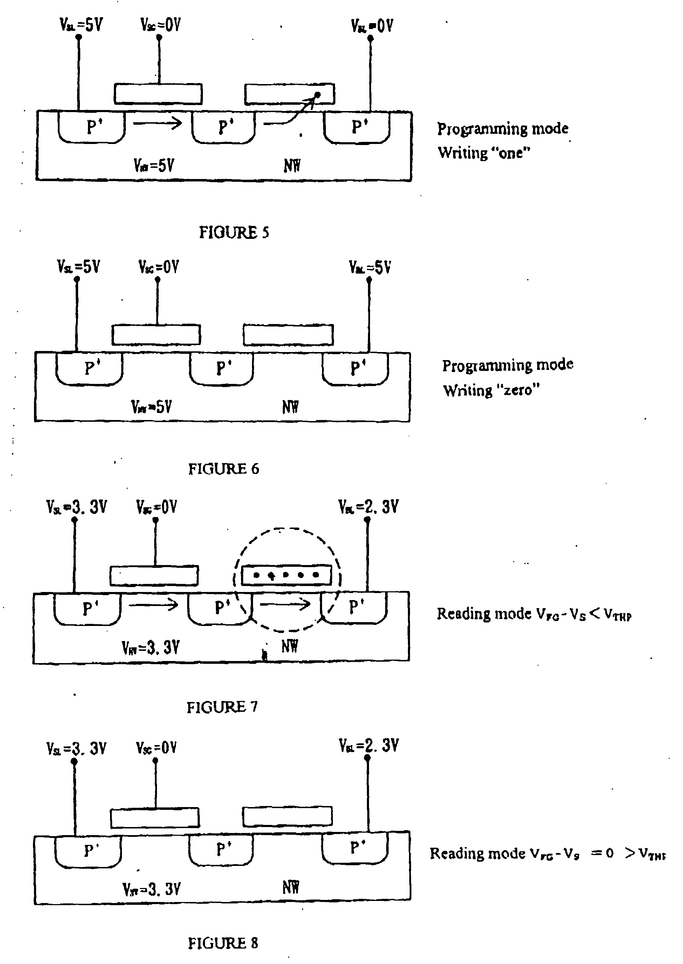

The conditions for writing a "digital one" and a "digital zero" refer to Table one and Fig.5 and Fig.6. During the mode for writing a "digital one", the selected word line is grounded and the unselected word line is set in a range of 3-8 volts, preferably about five volts. The selected bit line is grounded and the bias of the unselected bit line is set in a range of 3-8 volts, preferably 5 volts, bias applies on the source node and N well is connected to 3-8 volts. The PMOS transistor of the selected transistor turns on and the hot channel electron injects onto the floating gate of the second transistor.

During the mode for writing a "digital zero", the selected word line is grounded and 3-8 volts is biased to the unselected word line. The selected bit line is set to a range of 3-8 volts, preferably 5 volts and the unselected bit line is set to a range of 3-8 volts. The source node N well are respectively connected to 3-8 volts. The device is under the state of "off" and therefore the hot carrier is unable to inject into the floating gate.

During the read operation, the selected word line is grounded. The unselected word line is biased to 2.5-5 volts and selected bit line is biased to 3.3 volts. The source node is also biased to 2.5-5 volts. The N well is respectively connected to 2.5-5 volts. If the cell is programmed, the floating gate is charged with carrier, then V_{FG}-V_{S} < V_{THP} (threshold voltage of PMOS), the device maintains at the status of "ON". The floating gate of those unprogrammed cells have no charge therein, then V_{FG}-V_{S} = 0 > V_{THP} (threshold voltage of PMOS), the device at the status of "OFF".

As aforementioned, the device does not need the control gate for programming. The floating gate may self-charge to define the digital status. The feature of the present invention includes: the device can be manufactured by standard CMOS processes. The space for forming the control gate can be omitted, thereby reducing the layout area.

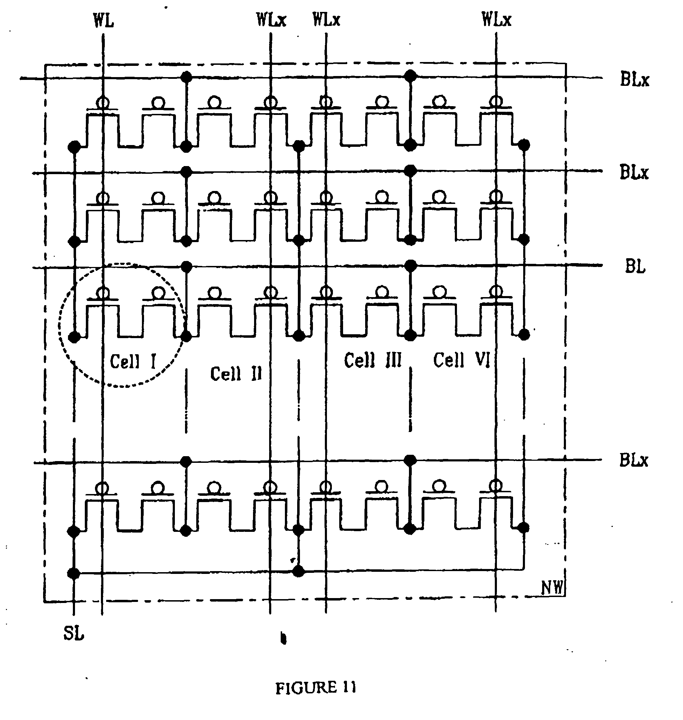

Fig. 11 illustrates the cell array. In cell I, in the mode for writing a "digital one", the drain is biased to five or six volts and the gate of select transistor is connected to ground. Other cells (cell I, cell III and cell IV) that are not under programming on the same bit line do not suffer the drain disturbance that typically occurs at stacked gate memory, this is because that the transistor is at an off-state and the electric field between the drain and floating gate is not strong enough to inject/generate hot carrier. Further, the potential coupling of the floating gate is not induced by the word line, thereby eliminating the gate disturbance phenomenon.

As will be understood by person skilled in the art, the foregoing preferred embodiment of the present invention is illustrative of the present invention rather than limiting the present invention. Having described the invention in connection with a preferred embodiment, modification will now suggest itself to those skilled in the art. Thus, the invention is not to be limited to this embodiment, but rather the invention is intended to cover various modifications and similar arrangements included within the spirit and scope of the appended claims, the scope of which should be accorded the broadest interpretation so as to encompass all such modifications and similar structures.

**TABLE ONE**

| Operation | Select | Unselect | Select | Unselect | Source line | N-well |
|---|---|---|---|---|---|---|
| | WL | WL | BL | BL | | |
| Write | 0 V | 5 V | 0 V | | 5 V | 5 V |
| one | | | | | | |
| Write | 0 V | 5 V | 5 V | 5 V | 5 V | 5 V |
| zero | | | | | | |
| Read | 0 V | 3.3 V | 3.3 V | 3.3 V | 3.3 V | 3.3 V |

While the preferred embodiment of the invention has been illustrated and described, it will be appreciated that various changes can be made therein without departing from the spirit and the scope of the invention.

## Claims

1. An erasable programmable read only memory comprising:
an N-well electrically coupled to a well voltage; and
two serially connected P-type metal-oxide semiconductor (MOS) transistors formed on said N-well, wherein a first P-type MOS transistor comprises:
a select gate formed over a channel region of said first P-type MOS transistor and being electrically coupled to a select gate voltage;
a first source region being electrically connected to a source line voltage; and
a first drain region;
and a second P-type MOS transistor comprises:
a second source region being electrically connected to said drain region of said first P-type MOS transistor;
a second drain region being electrically coupled to a bit line voltage; and
a floating gate formed over a floating gate channel defined by said second source region and said second drain region,
**characterized in that**
in a program mode, said floating gate acquires an induced floating gate voltage contributed by said bit line voltage, said well voltage, and said source region of said second P-type MOS transistor, wherein said floating gate voltage enables channel hot-electron injection in program mode, wherein during a mode for writing a "digital one", a selected word line is grounded and a unselected word line is biased to about a positive first voltage, wherein a selected bit line is grounded, an unselected bit line is about said first voltage, a source node and an N well are connected to said first voltage, thereby turning on said selected transistor and injecting hot channel carriers onto said floating gate of said second P-type metal-oxide semiconductor transistor.

2. The erasable programmable read only memory of claim 1 **characterized in that** said first voltage ranges from 3-8 volts.

3. The erasable programmable read only memory of claim 1 **characterized in that** during a mode for writing a "digital zero", a selected word line is grounded and an unselected word line is applied to a second voltage, a selected bit line is about said second voltage and an unselected bit line is also about said second voltage, a source node and an N well are respectively connected to said second voltage, thereby turning off said select transistor and hot carrier is unable to inject onto said floating gate.

4. The erasable programmable read only memory of claim 3 **characterized in that** said second voltage ranges from 3-8 volts.

5. The erasable programmable read only memory of claim 1 **characterized in that** during read mode, a selected word line is grounded and an unselected word line is biased to a third voltage, a selected bit line is about a forth voltage, an unselected bit line is biased to said third voltage, a source node is also biased to said third voltage and an N well is connected to said third voltage, thereby turning on said select transistor for reading the status stored in said floating gate.

6. The erasable programmable read only memory of claim 5 **characterized in that** said third voltage ranges from 2.5-5 volts.

7. The erasable programmable read only memory of claim 5 **characterized in that** said fourth voltage ranges from 0-2.5 volts.

8. The erasable programmable read only memory of claim 1 **characterized in that** in a cell array, an unselected transistor does not suffer a drain disturbance because said unselected transistor is in an off-state and the electric field between said bit line and said floating gate is not strong enough to inject/generate hot carriers, a coupling of said floating gate is not induced by the word line, thereby eliminating the gate disturbance phenomenon.

9. The erasable programmable read-only memory of claim 1 **characterized in that** during a programming operation a well voltage is applied to said N-well, a first voltage that is less than said well voltage is applied to said second P-doped drain region of said second P-type MOS transistor, thereby coupling a second voltage on said floating gate to turn on said second P-type MOS transistor.

10. The erasable programmable read only memory of claim 1,
**characterized in that**
said first source region, said first drain region, said second source region and said second drain region are formed by a doped region (2) that is shaped into an interrupted stripe structure having three regions and formed by ion implantation in a substrate;
said select gate is formed by a first conductive area (4) comprising a stripe structure and being disposed on said substrate forming a first cross structure with a first overlap area with said doped region (2); and
said floating gate is formed by a second conductive area (6) located at a side of said first conductive region and on said substrate forming a second cross structure with a second overlap area with said doped region (2).

## Patentansprüche

1. Löschbarer programmierbarer Festwertspeicher, umfassend:
eine N-Wanne, die elektrisch mit einer Wannenspannung gekoppelt ist; und
zwei seriell verbundene Metalloxidhalbleiter (MOS) - Transistoren vom P-Typ, die auf der N-Wanne ausgebildet sind, wobei
ein erster PMOS-Transistor umfasst:
ein Auswahlgate, das über einem Kanalbereich des ersten PMOS-Transistors ausgebildet ist und elektrisch mit einer Auswahlgatespannung gekoppelt ist;
einen ersten Source-Bereich, der elektrisch mit einer Source-Leitungsspannung verbunden ist; und
einen ersten Drain-Bereich;
und ein zweiter PMOS-Transistor umfasst:
einen zweiten Source-Bereich, der elektrisch mit dem Drain-Bereich des ersten PMOS-Transistors verbunden ist;
einen zweiten Drain-Bereich, der elektrisch mit einer Bitleitungs-Spannung gekoppelt ist; und
ein Floating-Gate, das über einem Floating-Gate-Kanal ausgebildet ist, der von dem zweiten Source-Bereich und dem zweiten Drain-Bereich definiert wird,
**dadurch gekennzeichnet, dass**
das Floating-Gate in einem Programmier-Modus eine induzierte Floating-Gate-Spannung annimmt, die von der Bitleitungs-Spannung, der Wannenspannung und dem Source-Bereich des zweiten PMOS-Transistors zugeführt wird, wobei die Floating-Gate-Spannung im Programmier-Modus eine Einkoppelung spannungsführender Elektronen in den Kanal, Channel Hot Electron Injection, ermöglicht, wobei während eines Modus zum Schreiben einer "digitalen Eins" eine ausgewählte Wortleitung geerdet und eine nicht ausgewählte Wortleitung mit einer Vorspannung beaufschlagt wird, die ungefähr einer positiven ersten Spannung entspricht, wobei eine ausgewählte Bitleitung geerdet wird, eine nicht ausgewählte Bitleitung bei ungefähr der ersten Spannung ist, ein Source-Knoten und eine N-Wanne mit der ersten Spannung verbunden sind, wodurch der ausgewählte Transistor eingeschaltet und die spannungsführenden Träger in das Floating-Gate des zweiten P-Typ Metalloxidhalbleiter-Transistor eingekoppelt werden.

2. Löschbarer programmierbarer Festwertspeicher nach Anspruch 1, **dadurch gekennzeichnet, dass** die erste Spannung zwischen 3 und 8 Volt liegt.

3. Löschbarer programmierbarer Festwertspeicher nach Anspruch 1, **dadurch gekennzeichnet, dass** während eines Modus zum Schreiben einer "digitalen Null" eine ausgewählte Wortleitung geerdet ist und eine nicht ausgewählte Wortleitung an einer zweiten Spannung angelegt ist, eine ausgewählte Bitleitung bei ungefähr der zweiten Spannung ist und eine nicht ausgewählte Bitleitung ebenfalls bei ungefähr der zweiten Spannung ist, ein Source-Knoten und eine N-Wanne jeweils mit der zweiten Spannung verbunden sind, wodurch der ausgewählte Transistor abgeschaltet wird und spannungsführende Träger nicht in der Lage sind, in das Floating-Gate einzukoppeln.

4. Löschbarer programmierbarer Festwertspeicher nach Anspruch 3, **dadurch gekennzeichnet, dass** die zweite Spannung zwischen 3 und 8 Volt liegt.

5. Löschbarer programmierbarer Festwertspeicher nach Anspruch 1, **dadurch gekennzeichnet, dass** während eines Lesemodus eine ausgewählte Wortleitung geerdet und eine nicht ausgewählte Wortleitung mit einer Vorspannung beaufschlagt wird, die einer dritten Spannung entspricht, eine ausgewählte Bitleitung auf ungefähr einer vierten Spannung ist, eine nicht ausgewählte Bitleitung mit einer Vorspannung beaufschlagt wird, die der dritten Spannung entspricht, ein Source-Knoten ebenfalls mit einer Vorspannung beaufschlagt wird, die der dritten Spannung entspricht und, eine N-Wanne mit der dritten Spannung verbunden ist, wodurch der ausgewählte Transistor eingeschaltet wird, um den in dem Floating-Gate gespeicherten Status zu lesen.

6. Löschbarer programmierbarer Festwertspeicher nach Anspruch 5, **dadurch gekennzeichnet, dass** die dritte Spannung zwischen 2,5 und 5 Volt liegt.

7. Löschbarer programmierbarer Festwertspeicher nach Anspruch 5, **dadurch gekennzeichnet, dass** die vierte Spannung zwischen 0 und 2,5 Volt liegt.

8. Löschbarer programmierbarer Festwertspeicher nach Anspruch 1, **dadurch gekennzeichnet, dass**
in einem Zellenfeld ein nicht ausgewählter Transistor keine Drain-Störung erfährt, da der nicht ausgewählte Transistor in einem Aus-Zustand ist und das elektrische Feld zwischen der Bitleitung und dem Floating-Gate nicht stark genug ist, um spannungsführende Träger einzukoppeln/zu erzeugen,
ein Koppeln des Floating-Gates von der Wortleitung nicht induziert wird,
wodurch das Gate-Störungsphänomen beseitigt wird.

9. Löschbarer programmierbarer Festwertspeicher nach Anspruch 1, **dadurch gekennzeichnet, dass** während eines Programmierungsvorgangs
eine Wannenspannung an der N-Wanne angelegt ist,
eine erste Spannung, die geringer als die Wannenspannung ist, am zweiten P-dotierten Drain-Bereich des zweiten PMOS-Transistors angelegt ist,
wodurch eine zweite Spannung in das Floating-Gate gekoppelt wird, um den zweiten PMOS-Transistor einzuschalten.

10. Löschbarer programmierbarer Festwertspeicher nach Anspruch 1, **dadurch gekennzeichnet, dass**
der erste Source-Bereich, der erste Drain-Bereich, der zweite Source-Bereich und der zweite Drain-Bereich von einem dotierten Bereich (2) gebildet werden, der in eine unterbrochene Streifenstruktur mit drei Bereich geformt ist und durch Ionenimplantation in einem Substrat ausgebildet ist;
das Auswahlgate durch einen ersten leitfähigen Bereich (4) ausgebildet ist, der eine Streifenstruktur umfasst und auf dem Substrat angeordnet ist, der eine erste Kreuzstruktur mit einem ersten überlappenden Bereich mit dem dotierten Bereich (2) bildet; und
das Floating-Gate durch einen zweiten leitfähigen Bereich (6) gebildet wird, der an einer Seite des ersten leitfähigen Bereichs und auf dem Substrat liegt, der eine zweite Kreuzstruktur mit einem zweiten überlappenden Bereich mit dem dotierten Bereich (2) bildet.

## Revendications

1. Mémoire morte programmable effaçable comprenant :
un puits N couplé électriquement à une tension de puits ; et
deux transistors métal oxyde semiconducteur (MOS) de type P montés en série, formés sur ledit puits N, où un premier transistor MOS de type P comprend :
une grille de sélection formée sur une région de canal dudit premier transistor MOS de type P et couplée électriquement à une tension de grille de sélection ;
une première région de source connectée électriquement à une tension de ligne de source ; et
une première région de drain ;
et un deuxième transistor MOS de type P comprend :
une deuxième région de source connectée électriquement à ladite région de drain dudit premier transistor MOS de type P ;
une deuxième région de drain couplée électriquement à une tension de ligne binaire ; et
une grille flottante formée sur un canal de grille flottante défini par ladite deuxième région de source et ladite deuxième région de drain,
**caractérisée en ce que**, dans un mode de programme, ladite grille flottante acquiert une tension de grille flottante induite fournie par ladite tension de ligne binaire, ladite tension de puits et ladite région de source dudit deuxième transistor MOS de type P, ladite tension de grille flottante permettant une injection d'électrons chauds de canal dans le mode de programme, dans lequel pendant un mode pour écrire un "un numérique", une ligne de mot choisie est mise à la masse et une ligne de mot non choisie est polarisée à peu près à une première tension positive, où une ligne binaire choisie est mise à la masse, une ligne binaire non choisie est autour de ladite première tension, un noeud de source et un puits N sont reliés à ladite première tension, rendant ainsi passant ledit transistor choisi et injectant des porteurs de canal chauds sur ladite grille flottante dudit deuxième transistor métal oxyde semiconducteur de type P.

2. Mémoire morte programmable effaçable selon la revendication 1, **caractérisée en ce que** ladite première tension est comprise dans l'intervalle de 3 à 8 volts.

3. Mémoire morte programmable effaçable selon la revendication 1, **caractérisée en ce que**, pendant un mode pour écrire un "un numérique", une ligne de mot choisie est mise à la masse et une ligne de mot non choisie est mise à une deuxième tension, une ligne binaire choisie est autour de ladite deuxième tension et une ligne binaire non choisie est aussi autour de ladite deuxième tension, un noeud de source et un puits N sont respectivement reliés à ladite deuxième tension, ce qui rend bloquant ledit transistor choisi et un porteur chaud n'est pas capable de s'injecter sur ladite grille flottante.

4. Mémoire morte programmable effaçable selon la revendication 3, **caractérisée en ce que** ladite deuxième tension est comprise dans l'intervalle de 3 à 8 volts.

5. Mémoire morte programmable effaçable selon la revendication 1, **caractérisée en ce que**, pendant un mode de lecture, une ligne de mot choisie est mise à la masse et une ligne de mot non choisie est polarisée à une troisième tension, une ligne binaire choisie est à peu près à une quatrième tension, une ligne binaire non choisie est polarisée à ladite troisième tension, un noeud de source est aussi polarisé à ladite troisième tension et un puits N est connecté à ladite troisième tension, rendant ainsi passant ledit transistor choisi pour lire l'état mémorisé dans ladite grille flottante.

6. Mémoire morte programmable effaçable selon la revendication 5, **caractérisée en ce que** ladite troisième tension est comprise dans l'intervalle de 2,5 à 5 volts.

7. Mémoire morte programmable effaçable selon la revendication 5, **caractérisée en ce que** ladite quatrième tension est comprise dans l'intervalle de 0 à 2,5 volts.

8. Mémoire morte programmable effaçable selon la revendication 1, **caractérisée en ce que**, dans un réseau de cellules, un transistor non choisi ne subit pas de perturbation de drain parce que ledit transistor non choisi est dans un état bloquant et le champ électrique entre ladite ligne binaire et ladite grille flottante n'est pas assez fort pour injecter/produire des porteurs chauds, un couplage de ladite grille flottante n'est pas induit par la ligne de mot, éliminant ainsi le phénomène de perturbation de grille.

9. Mémoire morte programmable effaçable selon la revendication 1, **caractérisée en ce que**, pendant une opération de programmation, une tension de puits est appliquée audit puits N, une première tension qui est inférieure à ladite tension de puits est appliquée à ladite deuxième région de drain dopée P dudit deuxième transistor MOS de type P, couplant ainsi une deuxième tension sur ladite grille flottante pour rendre passant ledit deuxième transistor MOS de type P.

10. Mémoire morte programmable effaçable selon la revendication 1, **caractérisée en ce que** :
ladite première région de source, ladite première région de drain, ladite deuxième région de source et ladite deuxième région de drain sont formées par une région dopée (2) qui a la forme d'une structure de bande interrompue ayant trois régions et formée par implantation d'ions dans un substrat ;
ladite grille de sélection est formée par une première zone conductrice (4) comprenant une structure de bande et disposée sur ledit substrat formant une première structure en croix comportant une première zone de chevauchement avec ladite région dopée (2) ; et
ladite grille flottante est formée par une deuxième zone conductrice (6) située sur un côté de ladite première région conductrice et sur ledit substrat formant une deuxième structure en croix comportant une deuxième zone de chevauchement avec ladite région dopée (2).
